# EUROPEAN PATENT SPECIFICATION

(11) **EP 4 439 657 B1**
(45) Date of publication and mention of the grant of the patent: **03.09.2025**
(21) Application number: 24164527.4
(22) Date of filing: 19.03.2024
(51) Int. Cl.: H05K 3/00

(54) **COMPONENT CARRIER AND MANUFACTURE METHOD THEREOF AND COMPONENT CARRIER ARRANGEMENT**
KOMPONENTENTRÄGER UND HERSTELLUNGSVERFAHREN DAFÜR SOWIE KOMPONENTENTRÄGERANORDNUNG
SUPPORT DE COMPOSANT ET SON PROCÉDÉ DE FABRICATION ET AGENCEMENT DE SUPPORT DE COMPOSANT

(30) Priority: 30.03.2023 CN 202310331362
(43) Date of publication of application: 02.10.2024
(73) Proprietor: AT & S Austria Technologie & Systemtechnik Aktiengesellschaft, 8700 Leoben-Hinterberg (AT)
(72) Inventor: Park, Hans, Chongqing, 401120 (CN); Mok, Jeesoo, 8700 Leoben (AT)
(74) Representative: Dilg, Haeusler, Schindelmann Patentanwaltsgesellschaft mbH

(56) References cited:
- US-A1- 2021 296 230

## Description

### Field of the Invention

The invention relates to a component carrier with a stack that comprises at least three electrically conductive layer structures, wherein a first line spacing and a second line spacing are larger than a third line spacing. Further, the invention relates to a method of manufacturing said component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, as shown in document US2021/296230A1, providing a component carrier with high density pattern metal traces may be considered a challenge under current technology. A general parameter to quantify a high-density pattern may be the line spacing (L/S), i.e. the compared width of metal traces and the space of the dielectric material portions between two metal traces. The smaller the line spacing, the higher may be the density of a metal trace pattern. In an example, an L/S of 12/12 µm or lower may be technically advantageous, for example with respect to miniaturization and (signal) transmission quality.

Even though miniaturization (while keeping the signal transmission quality constant) is an important trend in component carrier manufacture, there may still be drawbacks when providing high density patterns in component carriers, in particular regarding interconnections.

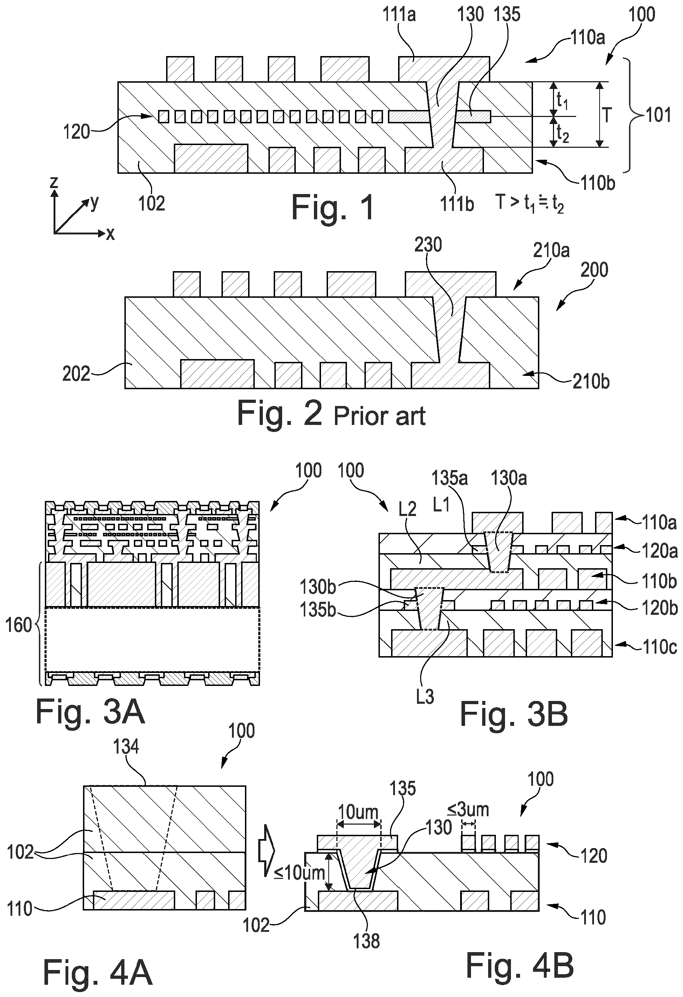

**Figure 2** shows an example of a conventional circuit board 200. A first metal trace 210a is arranged on top of a dielectric layer 202, while a second metal trace 210b is embedded at the bottom of the dielectric layer 202. The first metal trace 210a and the second metal trace 210b are interconnected by a via 230. Yet, in order to enable the electrical interconnection of the metal traces, only a large line-space ratio is applied (for example larger than 15/15 µm).

### Summary of the Invention

There may be a need to provide a component carrier with high density pattern and electrical interconnection in a reliable and economic manner.

A component carrier, a component carrier arrangement, and a manufacture method are described.

According to an aspect of the invention, there is described a component carrier comprising a stack with:
i) at least two electrically insulating layer structures (these may be separate or interconnected),
ii) a first electrically conductive layer structure (e.g. a metal trace), comprising a first line spacing, and at least one second electrically conductive layer structure, comprising a second line spacing, embedded in and/or provided on one of the at least two electrically insulating layer structures, respectively,
iii) at least one third electrically conductive layer structure, comprising a third line spacing, provided on and/or in one of the at least two electrically insulating layer structures,
   wherein the first line spacing and/or the second line spacing is larger than the third line spacing,
   wherein the third electrically conductive layer structure is arranged between (sandwiched between) the first electrically conductive layer structure and the second electrically conductive layer structure in the stacking direction (z) of the stack (the stacking direction may be in particular perpendicular to the stack main surfaces (directions of main extension), and/or parallel to the stack thickness direction), and
iv) an electrically conductive connection (e.g. a via) that electrically connects the first electrically conductive layer structure and the second electrically conductive layer structure in the stacking direction (z),
   wherein the electrically conductive connection passes through the third electrically conductive layer structure at a connection layer structure (e.g. a pad).

According to a further aspect of the invention, there is described a component carrier arrangement, comprising:
i) a component carrier (in particular as described above), and
ii) a component, in particular an electronic component or further component carrier (e.g. a motherboard), arranged on and/or in the component carrier.

According to a further aspect of the invention, there is described a method of manufacturing a component carrier, the method comprising:
i) forming at least one electrically insulating layer structure,
ii) forming a first electrically conductive layer structure, comprising a first line spacing in and/or on the electrically insulating layer structure,
iii) forming a third electrically conductive layer structure, comprising a third line spacing, in a stacking direction (z) on the first electrically conductive layer structure,
iv) forming a connection layer structure,
v) forming a second electrically conductive layer structure, comprising a second line spacing, in the stacking direction (z) on the second electrically conductive layer structure,
   wherein the first line spacing and the second line spacing is larger than the third line spacing; and
vi) forming an electrically conductive connection to electrically connect the first electrically conductive layer structure and the second electrically conductive layer structure in the stacking direction (z), so that the connection layer structure is arranged where the electrically conductive connection passes through the third electrically conductive layer structure.

In the context of the present document, the term "electrically conductive layer structure" may in particular refer to a trace that comprises a metal, in particular copper. In particular, a metal trace may be configured as an elongated (preferably in the horizontal direction) electrically conductive structure that may serve for the transmission of signals, in particular high frequency signals and/or high speed signals. Additionally or alternatively, the metal trace may conduct electric current, in particular current in the range of 1 pA - 1000 A. Further, a metal trace with a rough surface may establish an adhesion with dielectric material, thereby enhancing the stability of a component carrier. A metal trace having at least one smooth surface may provide higher speed of signal transmission. A metal trace may have for example a shape of an elongated trace, an annular ring or may be configured as a pad or block. Sidewalls of the metal traces can be straight or inclined/curved.

In the present context, the term "line spacing (L/S)" may in particular refer to a parameter that may be used to quantify the density of an electrically conductive layer structure pattern. While a high L/S ratio may indicate a low density pattern, a low L/S ratio (e.g. 12/12 µm or less, 5/5 µm or less, 3/3 µm or less) may indicate a high density pattern. When evaluating the L/S ratio, the component carrier may be seen in top view or in cross section and the metal traces may be considered as lines while the dielectric component carrier material between the lines may be seen as spaces. In general, the length of the lines and the length of the spaces are equal. Nevertheless, there may be examples, wherein L and S are not equal, but one is larger than the other, for example 9/12 or 14/17 in substrate technology.

In the context of the present document, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In the context of the present document, the term "electrically conductive connection" may in particular refer to a structure that interconnects at least two electrically conductive layer structures. In a preferred example, the electrically conductive connection may be configured as a vertical through connection, such as a via. Hereby, the via may be completely or partially filled with electrically conductive material (e.g. copper). In the later case, only the sidewalls of the electrically conductive connection may be electrically conductive, for example a plated through-hole. In an example, the electrically conductive connection is configured as a monolithic (circular or rectangular) pillar that extends in stack thickness direction with a constant diameter. The electrically conductive connection may extend along a straight line (linear, not-interrupted direction) or may comprise a curved shape. In an example, the electrically conductive connection is configured as a bump attached on the surface of a component carrier and/or a component as interconnection structure between the component carrier and the component.

In the context of the present document, the term "connection layer structure" may in particular refer to a part of an electrically conductive layer structure formed at a location/region, where the (vertically oriented) electrically conductive connection structure passes through the third/fourth electrically conductive layer structure (with the fine line spacing). The connection layer structure may herby serve as a pad, in particular a pad that may enable an efficient and robust connection to/through the third/fourth electrically conductive layer structure. In a specific example, the connection layer structure may comprise an extension perpendicular to the stacking direction of 10 µm or less, in particular 5 µm or less. Preferably, the connection layer structure may have similar or identical thickness (in stack thickness direction) as the third/fourth electrically conductive layer structure.

According to an exemplary embodiment, the invention may be based on the idea that a component carrier with a high density pattern may be provided in a reliable and economic manner, when electrically conductive layer structures with a different line spacing are formed in the same component carrier stack with a (vertical) interconnection, so that said interconnection passes through a fine line spacing layer structure at a pad-like connection layer structure.

Since layer structures with a fine line spacing (and high density) may be less robust (in particular regarding drilling processes), it may be a challenge to interconnect (through) such layer structures, and it may take a lot of cost to realize it. However, it has been found by the inventors, that such an interconnection may be realized in an especially efficient and reliable manner, when a pad-like connection layer structure is formed at the interface between interconnection via and fine line spacing layer structure.

In the described manner, within the same layer stack, different functionalities may be realized in an economic and straightforward manner. While the traces with the higher density may be used e.g. for signal transmission, where finer patterns may be advantageous, the traces with the lower density may be used for current transmission only, for example.

### Exemplary Embodiments

According to an embodiment, the first electrically conductive layer structure, the third electrically conductive layer structure, and the second electrically conductive layer structure are arranged one above the other along the vertical height (z) of the stack (in particular are arranged in parallel).

This may provide the advantage that a high density pattern may be provided only for specific layers, where this functionality may be especially required. These high density layer(s) may be sandwiched between layers of larger line spacing. The parallel architecture may enable an efficient and robust through connection between the layers. In an example, the component carrier may comprise a plurality of electrically conductive traces arranged at different vertical levels, wherein these traces serve for different purposes. The fine trace may transmit the high speed and/or high frequency signal.

According to a further embodiment, the thickness of the third electrically conductive layer structure is smaller than the thickness of the first electrically conductive layer structure and the second electrically conductive layer structure.

Different heights (along z direction) may reflect different manufacture methods and/or different metal layer (before forming the traces) thicknesses. Hence, not only the density (line spacing) of the traces (in different vertical levels) may be different but also the height of the electrically conductive layer structures. This may provide the advantage that different functionalities may be realized in an easy manner at different levels of the component carrier.

According to a further embodiment, the first line spacing and/or the second line spacing is 12/12 µm or smaller, in particular 10/10 µm or smaller, more in particular 8/8 µm or smaller. According to a further embodiment, the first line spacing and/or the second line spacing is 5/5 µm or larger, in particular 8/8 µm or larger, more in particular 10 µm or larger. According to a further embodiment, the third line spacing is 5/5 µm or smaller µm, in particular 3/3 µm or smaller, more in particular 2/2 µm or smaller. Depending on the desired application, a low line spacing may enable especially high density patterns and miniaturization, in particular of a component carrier or even high density patterns and miniaturization of a whole IC package.

According to a further embodiment, the largest extension of the electrically conductive connection perpendicular to the stacking direction (z) is 40 µm or smaller, in particular 10 µm or smaller (5 µm or smaller). Such a small extension of the via may further contribute to high density architecture and miniaturization, while still a highly efficient interconnection may be enabled.

According to a further embodiment, the component carrier further comprises: a fourth electrically conductive layer structure, comprising a fourth line spacing, in particular comparable to or equal to the third line spacing. In an example, the fourth electrically conductive layer structure is arranged in the stacking direction (z) above or below the first/second electrically conductive layer structure. In a further example, the fourth electrically conductive layer structure is arranged between the first electrically conductive layer structure and the second electrically conductive layer structure.

This may provide the advantage that high density pattern layer structures (traces) may be applied in a design-flexible manner. In one example, two or more layer structures with lower line spacing (e.g. third/fourth electrically conductive layer structure) may be sandwiched between two or more layer structures with a larger line spacing (e.g. first/second electrically conductive layer structure). In another example, two or more layer structures with larger line spacing (e.g. first/second electrically conductive layer structure) may be sandwiched between two or more layer structures with a lower line spacing (e.g. third/fourth electrically conductive layer structure).

In an example, the first and the second line spacing are larger than the fourth line spacing, and the third line spacing is different (smaller or larger) from the fourth line spacing.

According to a further embodiment, the electrically conductive connection extends through the fourth electrically conductive layer structure at a further connection layer structure. In this example, two or more layer structures with fine line spacing may be sandwiched between layer structures of larger line spacing. Each of the layer structures with fine line spacing may comprise a connection layer structure through which the electrically conductive connection (vertically) extends. This may provide the advantage that a plurality of conductive layer structures with different properties may be efficiently interconnected. Thereby, the design flexibility may be significantly increased.

According to a further embodiment, the largest extension of the electrically conductive connection perpendicular to the stacking direction (z) is different (in particular smaller or larger) to the largest extension of the connection layer structure. This may provide the advantage that the connection layer may serve as a robust stabilization of the electrically conductive connection. In case the electrically conductive connection is a tapering via (e.g. a laser via), it may comprise a plurality of extensions perpendicular to the stacking direction. In a specific example, the largest horizontal extension (along x) of the electrically conductive connection may be larger than (or equal to) the horizontal extension of the connection layer structure. In another example, the electrically conductive connection is a (essentially) straight via; for example, when the dielectric material is photo-imageable film and the via will be formed by exposure. In this case, the via tapering would be very small or there would be straight sidewalls.

According to a further embodiment, the component carrier further comprises a seed layer (in particular comprising titanium and/or copper). This may provide the advantage that a hole (pre-via) may be efficiently filled with plating using established technologies.

According to a further embodiment, the seed layer is arranged at at least one sidewall and/or the bottom of the electrically conductive connection.

According to a further embodiment, the seed layer is arranged at the bottom of the first electrically conductive layer structure and/or the second electrically conductive layer structure.

According to a further embodiment, the seed layer is arranged at the bottom of the second electrically conductive layer structure and/or the fourth electrically conductive layer structure. According to a further embodiment, the seed layer is arranged at at least one sidewall of the third and/or fourth electrically conductive layer structure.

In this manner, the seed layer (e.g. provided by sputtering or electro-less plating) may efficiently cover the required regions for filling the via. In particular, in case that the seed layer comprises titanium, in particular to improve the adhesion between the seed layer and dielectric layer (to avoid via crack or delamination), the seed layer may be easily detectable after via filling.

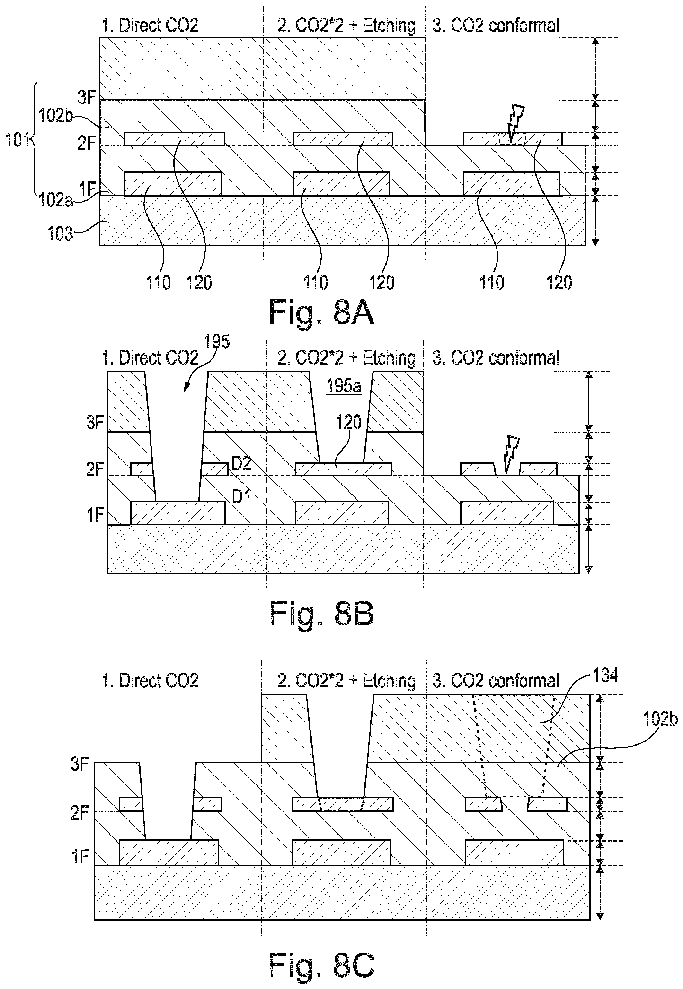

According to a further embodiment, the vertical extension of the electrically conductive connection comprises an undercut at the vertical height (z) of the connection layer structure. Such an undercut may reflect an etching step during manufacturing (see e.g. Figures 8A to 8G, second method). In an example, the seed layer comprises said undercut at the vertical height of the connection layer structure. Hereby, the undercut may be detectable after via filling based on the presence of the seed layer.

In the context of the present document, the term "undercut" may in particular refer to a disruption of the vertical extension of the electrical conductive connection or over etch, so that horizontal or inclined surfaces are provided in the intermediate vertical position on this vertical extension.

According to a further embodiment, the electrically conductive connection comprises a step, in particular horizontal step, directly above the vertical height (z) of the connection layer structure. Such a step may reflect a specific ("conformal") manufacturing process (see e.g. Figures 8A to 8G, third method), that applies two separate drilling steps and a pre-drilling of the third electrically conductive layer structure. In this embodiment, the upper part of the electrically conductive connection (above the connection layer structure) may be broader (larger extension in horizontal (x) direction, perpendicular to stacking direction) than the lower part of the electrically conductive connection (below the connection layer structure). This may bring the advantage of saving space inside the component carrier, especially in the lower part, which may be available for different constituents of the component carrier while still ensuring a highly reliable electrically conductive connection.

In an embodiment, the seed layer comprises said step. Hereby, the step may be detectable after via filling based on the presence of the seed layer. This may bring the advantage of enlarging the surface area between the seed layer and the electrically conductive material of the via, which ensures good connection between said parts.

According to a further embodiment, the component carrier further comprises a redistribution structure, in particular wherein the electrically conductive connection is directly connected to the redistribution layer structure. This may provide the advantage that the interconnection can be directly connected, via the redistribution structure, to another component (carrier).

In the context of the present document, the term "redistribution (layer) structure" may in particular refer to an electrically conductive structure that is designed to translate a small electric contact at a first surface to a large electric contact at a second surface, in particular wherein first and second surface are arranged opposed to each other. In an example, the redistribution layer structure comprises a plurality of vertical structures (vias) and horizontal structures (pad, traces) to enlarge the size of a first electric contact (i.e. a terminal of an IC) to the scale of a second electric contact (i.e. a solder ball to be mounted on a larger component carrier entity). In an example, the redistribution layer structure extends through an IC substrate.

According to a further embodiment of the component carrier arrangement, the component comprises an electronic component (e.g. active or passive) or a further component carrier, e.g. a motherboard, a temporary carrier, a substrate, etc.

According to a further embodiment of the component carrier arrangement, the arrangement is coreless and/or free of an interposer. This may enable a thin (yet stable) design that enables further miniaturization (especially in the z-direction).

According to a further embodiment of the method, forming the electrically conductive connection comprises: forming a hole, in particular using a laser, through the third electrically conductive layer structure down to the first electrically conductive layer structure (in particular then providing a seed layer). The method may further comprise: at least partially (in particular completely) filling the hole with electrically conductive material. A specific example of this method is described as the first method of Figures 8A to 8G. The drilling can be done in an example through a plurality of fine line spacing layer structures.

This may provide the advantage that the electrically conductive interconnection can be provided in a straightforward manner using established technology.

According to a further embodiment of the method, forming the electrically conductive connection comprises:
i) forming a hole, in particular using a laser, down to the third electrically conductive layer structure,
ii) performing an etching step to remove a part (or the oxidation) of the third electrically conductive layer structure at the hole bottom, thereby producing an undercut at the hole sidewall, and
iii) further forming the hole, in particular using the laser, down to the first electrically conductive layer structure (in particular then providing a seed layer).

In an example, the method further comprises at least partially filling the hole with electrically conductive material. A specific example of this method is described as the second method of Figures 8A to 8G. A plurality of layer structures with respective undercuts may be formed in the stack. In other words, an etching step (which produces the undercut) is applied between two hole forming (drilling) steps.

This may provide the advantage that an especially efficient manufacture may be provided, that avoids drilling through the fine line spacing layer structure. Due to the high density of said layer structure, a drilling process may be challenging or even destructive to the high density layer structure.

According to a further embodiment of the method, forming the electrically conductive connection comprises:
i) removing a part of the third electrically conductive layer structure, and afterwards
ii) embedding the third electrically conductive layer structure in one electrically insulating layer structure,
iii) forming a hole on the electrically insulating layer structure, in particular using a laser, down to the first electrically conductive layer structure, thereby producing a step (-like structure) between said electrically insulating layer structure and the third electrically conductive layer structure (in particular then providing a seed layer).

In an example, the method further comprises at least partially filling the hole with electrically conductive material. A specific example of this method is described as the third method of Figures 8A to 8G.

This may provide the advantage that an especially efficient manufacture may be provided, that avoids drilling through the fine line spacing layer structure together with drilling through the dielectric layer(s). Due to the high density of said layer structure, a drilling process may be challenging or even destructive to the high density layer structure. Hence, a hole through the fine line spacing layer structure may be formed with a separate process, when said layer structure is still exposed. Using this approach, an upper part of the electrically conductive connection may be broader than a lower part. A step-like structure may result in between the upper and lower part at the connection layer structure from this process.

According to a further embodiment of the method, forming the first and/or second electrically conductive layer structure and/or the third electrically conductive layer structure comprises a subtractive process and/or a semi-additive process, SAP, and/or a modified semi-additive process, mSAP. This may provide the advantage that established and efficient technologies may be directly applied.

In an embodiment, the component carrier is configured as one of the group consisting of a printed circuit board, a substrate (in particular an IC substrate), and an interposer.

In an embodiment, the component carrier is shaped as a plate. This contributes to the compact design and mass production, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

The aspects defined above and further aspects of the invention are apparent from the examples of embodiment to be described hereinafter and are explained with reference to these examples of embodiment.

### Brief Description of the Drawings

The aspects defined above and further aspects of the invention are apparent from the examples of embodiment to be described hereinafter and are explained with reference to these examples of embodiment.
Figure 1 shows a component carrier according to an exemplary embodiment of the invention.
Figure 2 shows a conventional circuit board.
Figures 3A and 3B respectively show a component carrier according to an exemplary embodiment of the invention.
Figures 4A and 4B respectively show a specific electronically conductive connection according to an exemplary embodiment of the invention.
Figures 5A to 5D show a method of manufacturing a component carrier according to an exemplary embodiment of the invention.
Figures 6A to 6C show a method of manufacturing a component carrier arrangement according to an exemplary embodiment of the invention.
Figures 7A to 7E show a method of manufacturing a specific component carrier according to an exemplary embodiment of the invention.
Figures 8A to 8G show a comparison of three methods of manufacturing a component carrier according to exemplary embodiments of the invention.
Figure 9 shows a component carrier with two directly opposite electrically conductive connections according to an exemplary embodiment of the invention.
Figure 10 shows a component carrier with two offset opposite electrically conductive connections according to an exemplary embodiment of the invention.
Figure 11 shows an alternative manufacture method according to an exemplary embodiment of the invention.
Figure 12 shows a component carrier with a step and an under-etch according to an exemplary embodiment of the invention.

### Detailed Description of the Drawings

The illustrations in the drawings are schematic. In different drawings, similar or identical elements are provided with the same reference signs.

Further, spatially relative terms, such as "front" and "back", "above" and "below", "left" and "right", et cetera are used to describe an element's relationship to another element(s) as illustrated in the figures. Thus, the spatially relative terms may apply to orientations in use which differ from the orientation depicted in the figures. Obviously all such spatially relative terms refer to the orientation shown in the figures only for ease of description and are not necessarily limiting as an apparatus according to an embodiment of the invention can assume orientations different than those illustrated in the figures when in use.

**Figure 1** shows a component carrier 100 (in particular a semi-finished component carrier) according to an exemplary embodiment of the invention. The component carrier 100 comprises a stack 101 with two interconnected electrically insulating layer structures 102. A first electrically conductive layer structure 110a is arranged on top of the electrically insulating layer structures 102 (in this example also on top of the stack 101) and comprises a first line spacing. A second electrically conductive layer structure 110b is embedded in the bottom electrically insulating layer structure 102 and comprises a second line spacing.

The component carrier 100 further comprises a third electrically conductive layer structure 120, which is embedded at the center of the stack 101 in the electrically insulating layer structures 102. Hereby, the third electrically conductive layer structure 120 is arranged between, i.e. sandwiched between, the first electrically conductive layer structure 110a and the second electrically conductive layer structure 110b in the stacking direction (z) of the stack 101.

The third electrically conductive layer structure 120 comprises a third line spacing, wherein the first line spacing and the second line spacing is larger than the third line spacing (in this example, the first and second line spacing are equal). In a specific example, the first line spacing and the second line spacing is around 12/12 µm (or 9/12um or 8/8um), while the third line spacing is around 5/5 µm or even smaller, such as 2/2 µm.

Thus, the first electrically conductive layer structure, the third electrically conductive layer structure, and the second electrically conductive layer structure are arranged one above the other in parallel along the vertical height (z) of the stack. The thickness of the third electrically conductive layer structure 120 is smaller than the thickness of the first electrically conductive layer structure 110a and the second electrically conductive layer structure 110b.

The distance (along the thickness direction) between the first and the second electrically conductive layer structure 110a, 110b is indicated as T, while the respective distance between the third electrically conductive layer structure 120 and the first and the second electrically conductive layer structure 110a, 110b is indicated as t1 and t2, in this example being equal, but could also be different, depending on the desired application.

The component carrier 100 further comprises an electrically conductive connection 130 that electrically connects the first electrically conductive layer structure 110a and the second electrically conductive layer structure 110b in the stacking direction (z), wherein the electrically conductive connection 130 passes through the third electrically conductive layer structure 120. The electrically conductive connection 130 is configured here as a via (vertical inter access), in particular a filled laser via. The via has a tapered shape or has a straight shape at the location, where the electrically conductive connection passes through the third electrically conductive layer structure 120, there is arranged a connection layer structure 135.

Said connection layer structure 135 is realized at the same vertical level as the third electrically conductive layer structure 120, however comprises a larger extension than given by the third line spacing. In the example shown, the connection layer structure 135 is configured as a (copper) pad around (and in direct physical contact) with the via 130. The largest extension of the electrically conductive connection 130 perpendicular to the stacking direction (i.e. along x and/or y) is different to the largest extension of the connection layer structure 135, in this example smaller.

**Figures 3A and 3B** respectively show a component carrier 100 according to an exemplary embodiment of the invention, wherein the semifinished component carrier 100 of Figure 1 has been further processed.

Figure 3A: further layer structures have been added on top. A redistribution structure 160 has been provided below. Thereby, the line spacing is varied (either increased or decreased) in the stack thickness direction. A detailed redistribution structure 160 is not depicted in Figure 3A, however the overall line spacing change between the top layer of the of the redistribution structure 160 and the bottom layer of the redistribution structure 160 is shown.

Figure 3B: a fourth electrically conductive layer structure 120b (in addition to the third electrically conductive layer structure 120a) with the fourth line spacing has been formed, also embedded in an electrically insulating layer structure 102. Additionally, a further (fifth) electrically conductive layer structure 110c with the first/second line spacing is provided. In this architecture, a first electrically conductive connection 130a electrically interconnects the first electrically conductive layer structure 110a, through a first connection layer structure 135a of the third electrically conductive layer structure 120a, to the second electrically conductive layer structure 110b. Thereby, the two electrically conductive connection 130a and 130b may connect with one ground copper plain, which may shorten the signal or power transmission path.

Further, a second electrically conductive connection 130b electrically connects the second electrically conductive layer structure 110b, through a second connection layer structure 135b of the fourth electrically conductive layer structure 120b, to the further electrically conductive layer structure 110c. Hereby, the first electrically conductive connection 130a and the second electrically conductive connection 130b (as well as the first connection layer structure 135a and the second connection layer structure 135b) are offset with respect to each other in the horizontal direction.

**Figures 4A and 4B** respectively show a specific electronically conductive connection according to an exemplary embodiment of the invention.

Figure 4A: a pre-via 134 is illustrated in two stacked electrically conductive layer structures 102 on top of an electrically conductive layer structure 110. In a further step, a hole will be drilled, e.g. by laser drilling, and then the via will be formed by plating.

Figure 4B: in this example, the component carrier 100 comprises a seed layer 138 of titanium and/or copper. Said seed layer 138 is arranged at the sidewalls and the bottom of the electrically conductive connection 130. Further, the seed layer 138 is at least partially arranged at the bottom of the first electrically conductive layer structure 110.

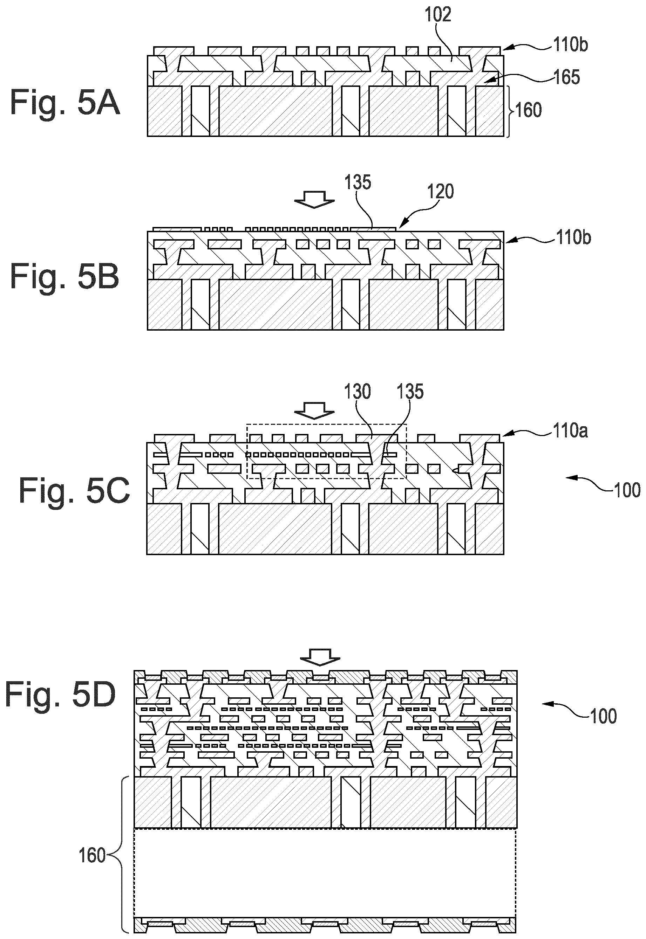

**Figures 5A to 5D** show a method of manufacturing a component carrier 100 according to an exemplary embodiment of the invention.

Figure 5A: an electrically insulating layer structure 102 is formed on top of a redistribution layer structure 160 with large redistribution structure vias 162. A second electrically conductive layer structure 110b, comprising a second line spacing, has been formed on top of the electrically insulating layer structure 102.

Figure 5B: the second electrically conductive layer structure 110b is embedded in a further electrically insulating layer structure 102, and a third electrically conductive layer structure 120, comprising a third line spacing, is formed on the further electrically insulating layer structure 102. The third electrically conductive layer structure 120 comprises hereby two connection layer structures 135 (pad) at the respective end in the horizontal direction (x). Said connection layer structures 135 are arranged vertically above via structures that interconnect the second electrically conductive layer structure 110b with the redistribution structure 160.

Figure 5C: the third electrically conductive layer structure 120 is embedded in electrically insulating material 102 and a first electrically conductive layer structure 110a, comprising a first line spacing, is formed on top of the electrically insulating layer structure 102. Furthermore, electrically conductive connection structures 130 are formed to interconnect vertically the first electrically conductive layer structure 110a with the second electrically conductive layer structure 110b, vertically above the via structures that interconnect the second electrically conductive layer structure 110b with the redistribution layer structure 160 The connection layer structures 135 are now located, where the electrically conductive connections 130 pass through the third electrically conductive layer structure 120, respectively. There might be an undercut or an over-etch (around 0.5 to 3 µm) at the sidewalls of bottom of the electrically connection 130.

Figure 5D: during further build-up, additional first, second, and third electrically conductive layer structures are formed. On top of the stack 101, a solder resist and a surface finish are provided. At the bottom, the redistribution structure 160 is formed (not shown in detail), also with a solder mask and surface finish.

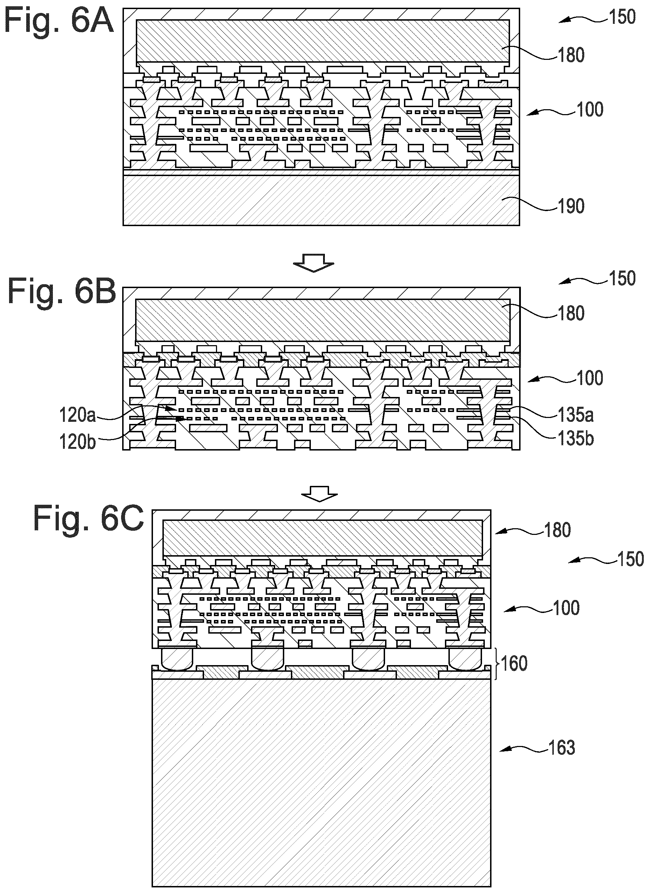

**Figures 6A to 6C** show a method of manufacturing a component carrier arrangement 150 according to an exemplary embodiment of the invention.

Figure 6A: a component carrier 100 is formed in a comparable manner as described for Figures 5A to 5D. Yet, the electrically conductive connection 130 extends through the fourth electrically conductive layer structure 120b at a further connection layer structure 135b. In other words, the third electrically conductive layer structure 120a and the fourth electrically conductive layer structure 120b are arranged on top of each other, without a first or second electrically conductive layer structure 110a, 110b in between, so that one electrically conductive connection 130 extends through the third electrically conductive layer structure 120a and the fourth electrically conductive layer structure 120b, in particular through respective connection layer structures 135. In this example, no redistribution structure 160 is used. It can be seen that the component carrier 100 has been manufactured attached to a temporary carrier 190. Furthermore, an electronic component 180 (semiconductor element) has been placed onto and electrically connected to the component carrier stack 101.

Figure 6B: the temporary carrier 190 has been removed.

Figure 6C: solder balls are attached to the bottom of the stack 101 as a redistribution structure 160. Then, the component carrier 100 is placed onto a further component carrier 163 (substrate) to form the component carrier arrangement 150.

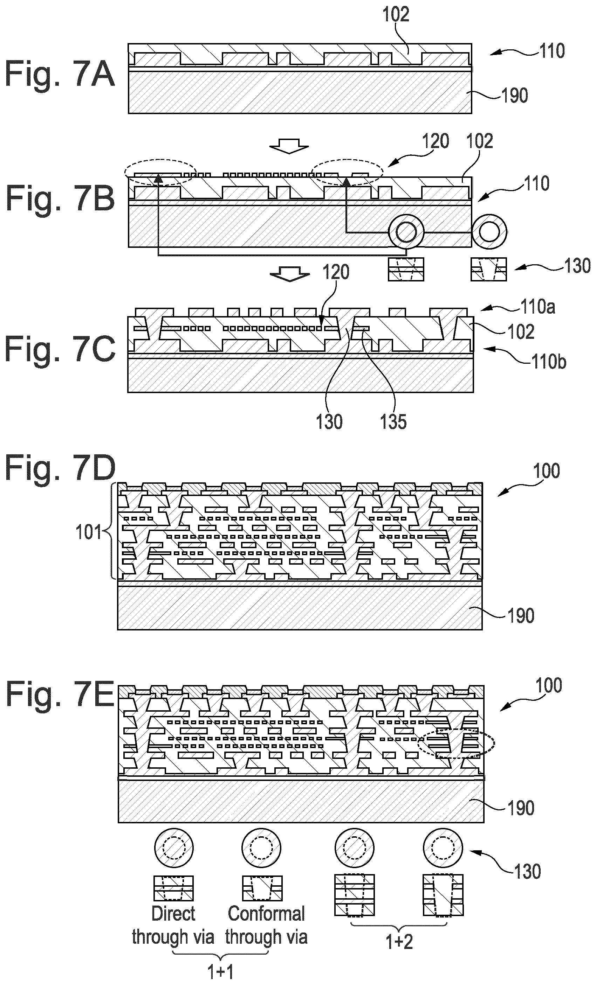

**Figures 7A to 7E** show a method of manufacturing a specific component carrier 100 according to an exemplary embodiment of the invention.

Figure 7A: on a temporary carrier 190, an electrically insulating layer structure 102 is formed with an embedded first electrically conductive layer structure 110.

Figure 7B: a third electrically conductive layer structure 120 is formed on top of the electrically insulating layer structure 102. It is shown it detailed view, that the electrically conductive connection 130 is either formed by drilling through a continuous connection layer structure 135 (left depiction in the detailed view) or through a non-continuous connection layer structure (right depiction in the detailed view) that also comprises an opening which might be formed by exposure or plasma at the hole forming (drilling) position.

Figure 7C: after embedding the third electrically conductive layer structure 120, the holes are drilled and are then filled with electrically conductive material to form the electrically conductive connections 130 through the connection layer structures 135.

Figure 7D: further build-up steps are performed to finish the component carrier 100.

Figure 7E: detailed views of the electrically conductive connections 130 are shown with different configurations: direct or conformal (see above) through one or two connection layer structures 135.

**Figures 8A to 8G** show a comparison of three methods of manufacturing a component carrier 100 according to exemplary embodiments of the invention. The first column shows a manufacturing process using drilling (here CO₂ laser or UV laser drilling) of a direct through via (compare Figure 7E). The second column shows a manufacturing process using two drilling steps with an etching step in between. The third column shows a manufacturing process using drilling of a conformal through via (also compare Figure 7E).

In all three examples, the starting structure comprises a first electrically insulating layer structure 102a with an embedded first/second electrically conductive layer structure 110, arranged on a core layer structure 103, and a second electrically insulating layer structure 102b on top of the first electrically insulating layer structure 102a, with an embedded third electrically conductive layer structure 120. In this example, the insulating layer structures 102a, 102b respectively comprise Ajinomoto Build-up Film (ABF), and the upper layer structure 102b is covered by a polyethylene terephthalate (PET) film.

### 1. First column (direct drilling)

Figures 8A to 8E: a hole 195 is formed through the PET film, the second electrically insulating layer structure 102b, the connection layer structure 135, and the first electrically insulating layer structure 102a, down to the first/second electrically conductive layer structure 110. The PET film has been removed.

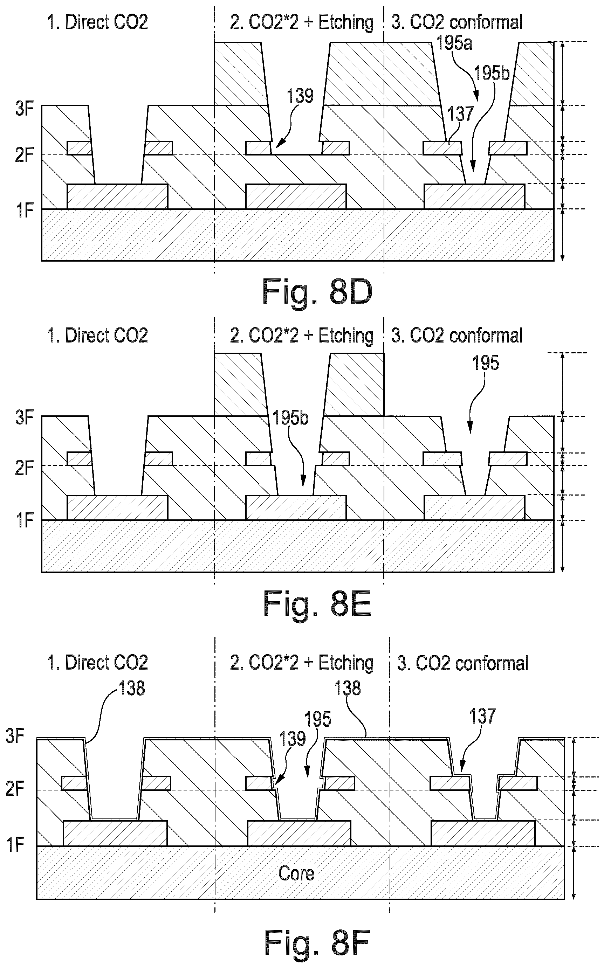

Figure 8F: a seed layer 138 is applied over the bottom, the sidewalls, and the stack upper surface of the drilled hole 195.

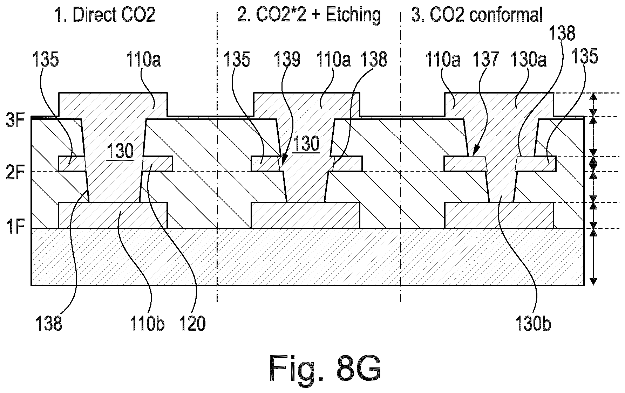

Figure 8G: the hole 195 is completely filled (plated) with copper to provide the electrically conductive connection 130.

### 2. Second column (drilling, etching, drilling)

Figures 8A and 8B: a first hole 195a is formed (drilled) through the second electrically insulating layer structure 102b down to the third electrically conductive layer structure 120.

Figures 8C and 8D: an etching step is performed to remove a part of the third electrically conductive layer structure 120 at the hole bottom. The part of the third electrically conductive layer structure 120, which is not exposed at the hole bottom, remains. Yet, due to the etching step, an undercut 139 is formed at the hole sidewalls.

Figure 8E: a second hole 195b is formed (drilled) through the first electrically insulating layer structure 102a, below the hole bottom, down to the first/second electrically conductive layer structure 110.

Figure 8F: a seed layer 138 is formed that covers the bottom of the hole 195 and the hole sidewalls, and also the stack upper surface. Eventually, also the undercut 139 is covered with the seed layer 138.

Figure 8G: the hole 195 is completely filled with electrically conductive material (copper). Thereby, a connection layer structure 135 is formed at the third electrically conductive layer structure 120. Even though the undercut 139 is also filled with the electrically conductive material, the seed layer 138 (and or another interface) is still detectable.

### 3. Third column (conformal drilling)

Figure 8A: in contrast to the first and the second method, the third method starts without the second electrically insulating layer structure 102b, i.e. the third electrically conductive layer structure 120 is exposed on top of the first electrically insulating layer structure 102a.

Figure 8B: an opening is formed through the third electrically conductive layer structure 120, e.g. using laser drilling (CO₂ or UV laser).

Figure 8C: the opening to be filled with and the third electrically conductive layer structure 120 is embedded in the second electrically insulating layer structure 102b. Further, the PET film is added on top.

Figure 8D: a first hole 195a with a larger diameter is formed through the second electrically insulating layer structure 102b using laser drilling, particular CO₂ or UV laser drilling, stopping at the stack thickness position, when the laser beam reaches the surface of the third electrically conductive layer structure 120. Afterwards, a second hole 195b is formed having the same (smaller) diameter as in the process step described in Figure 8B using laser drilling, in particular CO₂ or UV laser drilling, stopping at the stack thickness position, when the laser beam reaches the surface of the first/second electrically conductive layer structure 110. During the formation of the second hole 195b, the material of the first electrically insulating layer structure 102a is removed. Since the first hole 195a has been formed with a larger diameter than the second hole 195b, a step-like structure 137 remains between the second electrically insulating layer structure 102b and the third electrically conductive layer structure 120. This method could avoid the alignment issue between the via to pad.

Figure 8F: a seed layer 138 is formed that covers the bottom of the hole 195 and the hole sidewalls, and also the stack upper surface. Also, the step 137 is completely covered by the seed layer 138. It might generate the undercut or over-etch on the step 137 (generally seed layer plating by e.g. electroless plating will create the undercut on the bottom of via).

Figure 8G: the hole 195 is completely filled with electrically conductive material (copper). Thereby, a connection layer structure 135 is formed at the third electrically conductive layer structure 120. Even though the step 137 is also filled with the electrically conductive material, the seed layer 138 (and or another interface) is still detectable. Additionally, the horizontal extension (along x) of the upper part 130a (above the connection layer structure 135) of the electrically conductive connection 130 is larger than the horizontal extension (along x) of the lower part 130b (below the connection layer structure 135) of the electrically conductive connection 130.

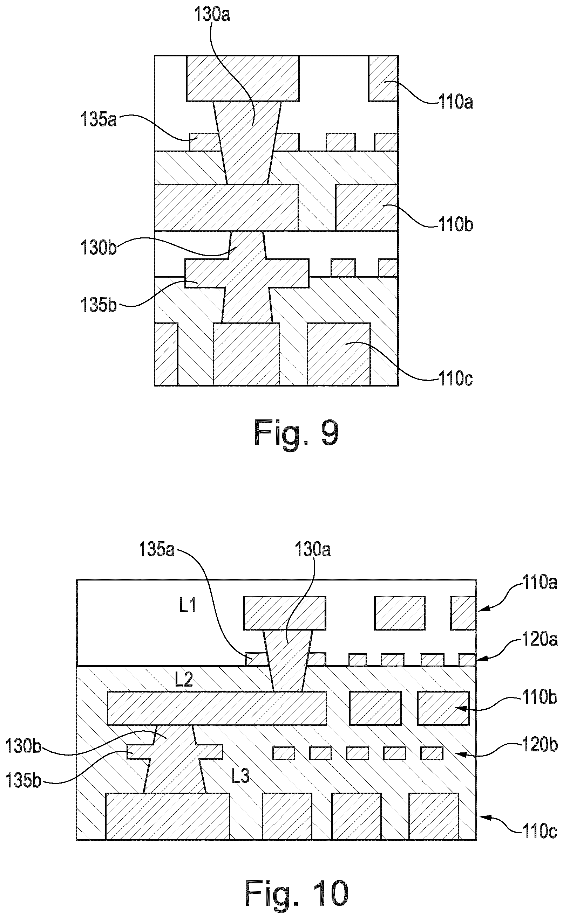

**Figure 9** shows a component carrier 100 with two directly opposite electrically conductive connections 130a, 130b (which are electrically connected at the second electrically conductive laver structure 110b) according to an exemplary embodiment of the invention. The tapering angle from the second electrically conductive layer structure 110b to the further electrically conductive laver structure 110c, and the tapering angle from the first electrically conductive laver structure 110a to the second electrically conductive laver structure 100b is the here same, so that a straight line may be created without a kink. In other words, the electrically conductive connections 130a, 130b are arranged so that they taper in opposite directions, the smallest diameters being in closest proximity, while the largest diameter being distant from each other.

Yet, in another embodiment, a kink is possible especially in the third option of the manufacturing methods described in Figures 8A to 8G. In this case, the tapering angles may be different. Furthermore, a (modified) hour glass shape can be enabled in this embodiment (if the electrically conductive layers are connected as described in Fig. 3B).

**Figure 10** shows a component carrier with two offset (with respect to each other) opposite electrically conductive connections 130a, 130b according to an exemplary embodiment of the invention. Thus, in comparison to the architecture described for Fig. 9 above, these electrically conductive connections 130a, 130b, that taper in opposite directions, are shifted with respect to each other in the horizontal direction (x, y).

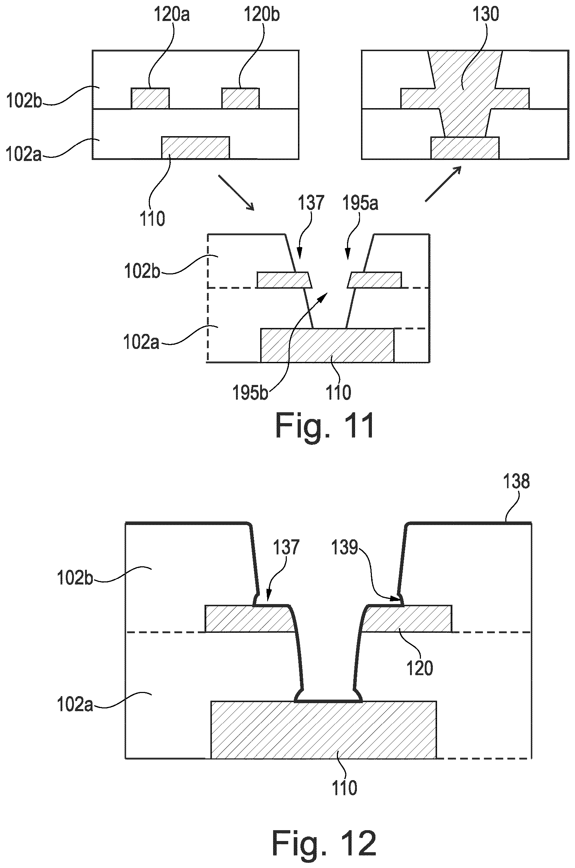

**Figure 11** shows an alternative manufacture method according to an exemplary embodiment of the invention. The manufacture is comparable to the third option of Figures 8A to 8G. Yet, in this architecture, there are two pads 120a, 120b of the third electrically insulating layer structure 120 instead of one big pad (see Figures 8A to 8G). Then, the laser can drill through the two insulating layer structures 102a, 102b (e.g. ABF) for via formation (like the via passing by the pad and electrically connect with the pad once the via filling with conductive material). But there might be an issue during the production of such as alignment and/or copper over-etch of the two small pad edges during laser drilling; therefore, the laser drilling can be separated into two steps (like in Figures 8D-8F) (drilling the first insulating layer 102b and stop on the two small pads 120a, 120b, then there will be a step 137 formed by the pads and then, drilling the insulating layer 102a for the whole via formation 130).

**Figure 12** shows a component carrier with a step 137 and an over-etch 139 according to an exemplary embodiment of the invention. This architecture is comparable with the one manufactured during the steps of Figures 8D to 8F. Yet, an undercut or over-etch 139 is formed on the step 137. In an example, a seed layer plating by electroless plating may form an undercut on the step and/or on the bottom of the hole.

It should be noted that the term "comprising" does not exclude other elements or steps, and the use of the item "a" does not exclude multiplicity. Elements described in conjunction with various embodiments can also be combined. It should also be noted that reference signs in the claims should not be interpreted as limiting the scope of the claims.

### Reference signs

- 100: Component carrier
- 101: Stack
- 102: Electrically insulating layer structure
- 110, 110a: First electrically conductive layer structure, first line spacing
- 110b: Second electrically conductive layer structure, second line spacing
- 111: Outer connection layer structure
- 120, 120a: Third electrically conductive layer structure, third line spacing
- 120b: Fourth electrically conductive layer structure, fourth line spacing
- 130: Electrically conductive connection, via
- 134: Pre-via
- 135: Connection layer structure
- 137: Step
- 138: Seed layer, sputtered layer
- 139: Undercut
- 150: Component carrier arrangement
- 160: Redistribution structure
- 162: Redistribution structure via
- 163: Substrate
- 165: Fifth electrically conductive layer structure, fifth line spacing
- 180: Component, semiconductor element
- 190: Temporary carrier
- 195: Hole
- 195a: First hole
- 195b: Second hole

## Claims

1. A component carrier (100), comprising a stack (101) with:
at least two electrically insulating layer structure (102);
a first electrically conductive layer structure (110a), comprising a first line spacing, and at least one second electrically conductive layer structure (110b), comprising a second line spacing, embedded in and/or provided on one of the at least two electrically insulating layer structures (102), respectively;
at least one third electrically conductive layer structure (120), comprising a third line spacing, provided on and/or in one of the at least two electrically insulating layer structures (102),
wherein the first line spacing and the second line spacing is larger than the third line spacing,
wherein the third electrically conductive layer structure (120) is arranged between the first electrically conductive layer structure (110a) and the second electrically conductive layer structure (110b) in the stacking direction (z) of the stack (101); and
an electrically conductive connection (130) that electrically connects the first electrically conductive layer structure (110a) and the second electrically conductive layer structure (110b) in the stacking direction (z),
**characterized in that**
the electrically conductive connection (130) passes through the third electrically conductive layer structure (120) at a connection layer structure (135).

2. The component carrier (100) according to claim 1, wherein at least one of the following features applies:
wherein the first electrically conductive layer structure (110a), the third electrically conductive layer structure (120), and the second electrically conductive layer structure (110b) are arranged one above the other along the vertical height (z) of the stack (101), in particular are arranged in parallel;
wherein the thickness of the third electrically conductive layer structure (120) is smaller than the thickness of the first electrically conductive layer structure (110a) and the second electrically conductive layer structure (110b);
wherein the first line spacing and the second line spacing is 12/12 µm or smaller, in particular 10/10 µm or smaller, more in particular 8/8 µm or smaller; and/or wherein the third line spacing is 5/5 µm or smaller µm, in particular 3/3 µm or smaller, more in particular 2/2 µm or smaller;
wherein the largest extension of the electrically conductive connection (130) perpendicular to the stacking direction (z) is 40 µm or smaller, in particular 10 µm or smaller.

3. The component carrier (100) according to claim 1 or 2,
further comprising:
a fourth electrically conductive layer structure (120b), comprising a fourth line spacing, in particular comparable to or equal to the third line spacing, arranged in the stacking direction (z) above or below the second electrically conductive layer structure (120a), and between the first electrically conductive layer structure (110a) and the second electrically conductive layer structure (110b).

4. The component carrier (100) according to claim 3,
wherein the electrically conductive connection (130) extends through the fourth electrically conductive layer structure (120b) at a further connection layer structure (135b).

5. The component carrier (100) according to any one of the preceding claims, wherein the largest extension of the electrically conductive connection (130) perpendicular to the stacking direction (z) is different to the largest extension of the connection layer structure (135).

6. The component carrier (100) according to claim 3,
further comprising:
a seed layer (138), in particular comprising titanium and/or copper;
wherein the seed layer (138) is arranged at at least one sidewall and/or the bottom of the electrically conductive connection (130); and/or wherein the seed layer (138) is arranged at the bottom of the first electrically conductive layer structure (110a) and/or the second electrically conductive layer structure (110b); and/or
wherein the seed layer (138) is arranged at the bottom of the second electrically conductive layer structure (120a) and/or the fourth electrically conductive layer structure (120b).

7. The component carrier (100) according to claim 6,
wherein the vertical extension of the electrically conductive connection (130) comprises an undercut (139) at the vertical height (z) of the connection layer structure (135),
in particular wherein the seed layer (138) comprises said undercut (139) at the vertical height of the connection layer structure (135).

8. The component carrier (100) according to claim 6,
wherein the electrically conductive connection (130) comprises a step (137), in particular horizontal step, directly above the vertical height (z) of the connection layer structure (135),
in particular wherein the seed layer (138) comprises said step (137).

9. The component carrier (100) according to any one of the preceding claims, further comprising:
a redistribution structure (160), in particular wherein the electrically conductive connection (130) is directly connected to the redistribution structure (160).

10. A component carrier arrangement (150), comprising:
a component carrier (100) according to any one of the preceding claims; and
a component (180, 190), in particular a further component carrier, arranged on and/or in the component carrier (100);
in particular, wherein the component carrier arrangement (150) is coreless and/or free of an interposer.

11. A method of manufacturing a component carrier (100), the method comprising:
forming at least one electrically insulating layer structure (102);
forming a first electrically conductive layer structure (110a), comprising a first line spacing, in and/or on the electrically insulating layer structure (102);
forming a third electrically conductive layer structure (120), comprising a third line spacing, in a stacking direction (z) on the first electrically conductive layer structure (110a);
forming a connection layer structure (135);
forming a second electrically conductive layer structure (110b), comprising a second line spacing, in the stacking direction (z) on the third electrically conductive layer structure (120),
wherein the first line spacing and the second line spacing is larger than the third line spacing;
forming an electrically conductive connection (130) to electrically connect the first electrically conductive layer structure (110a) and the second electrically conductive layer structure (110b) in the stacking direction (z), so that the connection layer structure (135) is arranged where the electrically conductive connection (130) passes through the third electrically conductive layer structure (120).

12. The method according to claim 11, wherein forming the electrically conductive connection (130) comprises:
forming a hole (195), in particular using a laser, through the third electrically conductive layer structure (120) down to the electrically conductive layer structure (110), in particular then providing a seed layer (138); and
at least partially filling the hole (195) with electrically conductive material.

13. The method according to claim 11, wherein forming the electrically conductive connection (130) comprises:
forming a hole (195a), in particular using a laser, down to the third electrically conductive layer structure (120);
performing an etching step to remove a part of the third electrically conductive layer structure (120) at the hole bottom, thereby producing an undercut (139) at the hole sidewall;
further forming the hole (195b), in particular using the laser, down to the electrically conductive layer structure (110), in particular then providing a seed layer (138); and
at least partially filling the hole (195) with electrically conductive material.

14. The method according to claim 11, wherein forming the electrically conductive connection (130) comprises:
removing a part of the third electrically conductive layer structure (120), and afterwards
embedding the third electrically conductive layer structure (120) in one electrically insulating layer structure (102);
forming a hole (195) on the electrically insulating layer structure (102), in particular using a laser, down to the electrically conductive layer structure (110), thereby producing a step (137) between said electrically insulating layer structure (102) and the third electrically conductive layer structure (120), in particular then providing a seed layer (138); and
at least partially filling the hole (195) with electrically conductive material.

15. The method according to any one of the claims 11 to 14,
wherein forming the first and/or second electrically conductive layer structure (110) and/or the third electrically conductive layer structure (120) comprises a subtractive process and/or a semi-additive process, and/or a modified semi-additive process.

## Patentansprüche

1. Ein Komponententräger (100), aufweisend einen Stapel (101) mit:
mindestens zwei elektrisch isolierenden Schichtstrukturen (102);
einer ersten elektrisch leitfähigen Schichtstruktur (110a), aufweisend einen ersten Leitungsabstand, und mindestens einer zweiten elektrisch leitfähigen Schichtstruktur (110b), aufweisend einen zweiten Leitungsabstand, eingebettet in und/oder vorgesehen auf jeweils einer der mindestens zwei elektrisch isolierenden Schichtstrukturen (102);
mindestens einer dritten elektrisch leitfähigen Schichtstruktur (120), aufweisend einen dritten Leitungsabstand, vorgesehen auf und/oder in einer der mindestens zwei elektrisch isolierenden Schichtstrukturen (102),
wobei der erste Leitungsabstand und der zweite Leitungsabstand größer als der dritte Leitungsabstand ist,
wobei die dritte elektrisch leitfähige Schichtstruktur (120) zwischen der ersten elektrisch leitfähigen Schichtstruktur (110a) und der zweiten elektrisch leitfähigen Schichtstruktur (110b) in Stapelrichtung (z) des Stapels (101) angeordnet ist; und
einer elektrisch leitfähigen Verbindung (130), welche die erste elektrisch leitfähige Schichtstruktur (110a) und die zweite elektrisch leitfähige Schichtstruktur (110b) in Stapelrichtung (z) elektrisch verbindet,
**dadurch gekennzeichnet, dass**
die elektrisch leitfähige Verbindung (130) die dritte elektrisch leitfähige Schichtstruktur (120) an einer Verbindungsschichtstruktur (135) durchdringt.

2. Der Komponententräger (100) gemäß Anspruch 1, wobei zumindest eines der folgenden Merkmale zutrifft:
wobei die erste elektrisch leitfähige Schichtstruktur (110a), die dritte elektrisch leitfähige Schichtstruktur (120) und die zweite elektrisch leitfähige Schichtstruktur (110b) entlang der vertikalen Höhe (z) des Stapels (101) übereinander angeordnet sind, insbesondere parallel angeordnet sind;
wobei die Dicke der dritten elektrisch leitfähigen Schichtstruktur (120) kleiner ist als die Dicke der ersten elektrisch leitfähigen Schichtstruktur (110a) und der zweiten elektrisch leitfähigen Schichtstruktur (110b);
wobei der erste Leitungsabstand und der zweite Leitungsabstand 12/12 µm oder kleiner, insbesondere 10/10 µm oder kleiner, weiter insbesondere 8/8 µm oder kleiner, ist; und/oder wobei der dritte Leitungsabstand 5/5 µm oder kleiner, insbesondere 3/3 µm oder kleiner, weiter insbesondere 2/2 µm oder kleiner, ist;
wobei die größte Ausdehnung der elektrisch leitfähigen Verbindung (130) senkrecht zur Stapelrichtung (z) 40 µm oder kleiner, insbesondere 10 µm oder kleiner, ist.

3. Der Komponententräger (100) gemäß Anspruch 1 oder 2,
ferner aufweisend:
eine vierte elektrisch leitfähige Schichtstruktur (120b), aufweisend einen vierten Leitungsabstand, insbesondere vergleichbar oder gleich dem dritten Leitungsabstand, angeordnet in Stapelrichtung (z) oberhalb oder unterhalb der zweiten elektrisch leitfähigen Schichtstruktur (120a), und zwischen der ersten elektrisch leitfähigen Schichtstruktur (110a) und der zweiten elektrisch leitfähigen Schichtstruktur (110b).

4. Der Komponententräger (100) gemäß Anspruch 3,
wobei sich die elektrisch leitfähige Verbindung (130) durch die vierte elektrisch leitfähige Schichtstruktur (120b) an einer weiteren Verbindungsschichtstruktur (135b) erstreckt.

5. Der Komponententräger (100) gemäß einem der vorhergehenden Ansprüche,
wobei sich die größte Ausdehnung der elektrisch leitfähigen Verbindung (130) rechtwinklig zur Stapelrichtung (z) von der größten Ausdehnung der Verbindungsschichtstruktur (135) unterscheidet.

6. Der Komponententräger (100) gemäß Anspruch 3,
ferner aufweisend:
eine Keimschicht (138), insbesondere aufweisend Titan und/oder Kupfer;
wobei die Keimschicht (138) an zumindest einer Seitenwand und/oder dem Boden der elektrisch leitfähigen Verbindung (130) angeordnet ist; und/oder
wobei die Keimschicht (138) am Boden der ersten elektrisch leitfähigen Schichtstruktur (110a) und/oder der zweiten elektrisch leitfähigen Schichtstruktur (110b) angeordnet ist; und/oder
wobei die Keimschicht (138) am Boden der zweiten elektrisch leitfähigen Schichtstruktur (120a) und/oder der vierten elektrisch leitfähigen Schichtstruktur (120b) angeordnet ist.

7. Der Komponententräger (100) gemäß Anspruch 6,
wobei die vertikale Ausdehnung der elektrisch leitfähigen Verbindung (130) einen Hinterschnitt (139) an der vertikalen Höhe (z) der Verbindungsschichtstruktur (135) aufweist,
insbesondere wobei die Keimschicht (138) den besagten Hinterschnitt (139) an der vertikalen Höhe der Verbindungsschichtstruktur (135) aufweist.

8. Der Komponententräger (100) gemäß Anspruch 6,
wobei die elektrisch leitfähige Verbindung (130) eine Stufe (137), insbesondere horizontale Stufe, direkt über der vertikalen Höhe (z) der Verbindungsschichtstruktur (135) aufweist,
insbesondere wobei die Keimschicht (138) die besagte Stufe (137) aufweist.

9. Der Komponententräger (100) gemäß einem der vorhergehenden Ansprüche,
ferner aufweisend:
eine Umverteilungsstruktur (160), insbesondere wobei die elektrisch leitfähige Verbindung (130) direkt mit der Umverteilungsstruktur (160) verbunden ist.

10. Eine Komponententrägeranordnung (150), aufweisend:
einen Komponententräger (100) gemäß einem der vorhergehenden Ansprüche; und
eine Komponente (180, 190), insbesondere einen weiteren Komponententräger, angeordnet auf und/oder in dem Komponententräger (100);
insbesondere wobei die Komponententrägeranordnung (150) kernlos und/oder frei von einem Interposer ist.

11. Ein Verfahren zum Herstellen eines Komponententrägers (100), das Verfahren aufweisend:
Bilden mindestens einer elektrisch isolierenden Schichtstruktur (102);
Bilden einer ersten elektrisch leitfähigen Schichtstruktur (110a), aufweisend einen ersten Leitungsabstand, in und/oder auf der elektrisch isolierenden Schichtstruktur (102);
Bilden einer dritten elektrisch leitfähigen Schichtstruktur (120), aufweisend einen dritten Leitungsabstand, in Stapelrichtung (z) auf der ersten elektrisch leitfähigen Schichtstruktur (110a);
Bilden einer Verbindungsschichtstruktur (135);
Bilden einer zweiten elektrisch leitfähigen Schichtstruktur (110b), aufweisend einen zweiten Leitungsabstand, in Stapelrichtung (z) auf der dritten elektrisch leitfähigen Schichtstruktur (120),
wobei der erste Leitungsabstand und der zweite Leitungsabstand größer als der dritte Leitungsabstand ist;
Bilden einer elektrisch leitfähigen Verbindung (130), um die erste elektrisch leitfähige Schichtstruktur (110a) und die zweite elektrisch leitfähige Schichtstruktur (110b) in Stapelrichtung (z) elektrisch zu verbinden, so dass die Verbindungsschichtstruktur (135) dort angeordnet ist, wo die elektrisch leitfähige Verbindung (130) die dritte elektrisch leitfähige Schichtstruktur (120) durchdringt.

12. Das Verfahren gemäß Anspruch 11, wobei das Bilden der elektrisch leitfähigen Verbindung (130) aufweist:
Bilden eines Lochs (195), insbesondere unter Verwendung eines Lasers, durch die dritte elektrisch leitfähige Schichtstruktur (120) bis hinunter zu der elektrisch leitfähigen Schichtstruktur (110), insbesondere dann Bereitstellen einer Keimschicht (138); und
zumindest teilweises Füllen des Lochs (195) mit elektrisch leitfähigem Material.

13. Das Verfahren gemäß Anspruch 11, wobei das Bilden der elektrisch leitfähigen Verbindung (130) aufweist:
Bilden eines Lochs (195a), insbesondere unter Verwendung eines Lasers, bis hinunter zu der dritten elektrisch leitfähigen Schichtstruktur (120);
Durchführen eines Ätzschritts, um einen Teil der dritten elektrisch leitfähigen Schichtstruktur (120) an dem Lochboden zu entfernen, wodurch ein Hinterschnitt (139) an der Lochseitenwand erzeugt wird;
weiteres Bilden des Lochs (195b), insbesondere unter Verwendung des Lasers, bis hinunter zu der elektrisch leitfähigen Schichtstruktur (110), insbesondere dann Bereitstellen einer Keimschicht (138); und
zumindest teilweises Füllen des Lochs (195) mit elektrisch leitfähigem Material.

14. Das Verfahren gemäß Anspruch 11, wobei das Bilden der elektrisch leitfähigen Verbindung (130) aufweist:
Entfernen eines Teils der dritten elektrisch leitfähigen Schichtstruktur (120), und danach
Einbetten der dritten elektrisch leitfähigen Schichtstruktur (120) in eine elektrisch isolierende Schichtstruktur (102);
Bilden eines Lochs (195) auf der elektrisch isolierenden Schichtstruktur (102), insbesondere unter Verwendung eines Lasers, bis hinunter zu der elektrisch leitfähigen Schichtstruktur (110), wodurch ein Schritt (137) zwischen der elektrisch isolierenden Schichtstruktur (102) und der dritten elektrisch leitfähigen Schichtstruktur (120) erzeugt wird, insbesondere dann Bereitstellen einer Keimschicht (138); und
zumindest teilweises Füllen des Lochs (195) mit elektrisch leitfähigem Material.

15. Das Verfahren gemäß einem der Ansprüche 11 bis 14,
wobei das Bilden der ersten und/oder zweiten elektrisch leitfähigen Schichtstruktur (110) und/oder der dritten elektrisch leitfähigen Schichtstruktur (120) einen subtraktiven Prozess und/oder einen semiadditiven Prozess und/oder einen modifizierten semiadditiven Prozess aufweist.

## Revendications

1. Support de composant (100), comprenant un empilement (101) avec :
au moins deux structures de couche électriquement isolante (102) ;
une première structure de couche électroconductrice (110a), comprenant un premier espacement de ligne, et au moins une deuxième structure de couche électroconductrice (110b), comprenant un deuxième espacement de ligne, intégrées dans et/ou fournies sur une certaine des au moins deux structures de couche électriquement isolante (102), respectivement ;
au moins une troisième structure de couche électroconductrice (120), comprenant un troisième espacement de ligne, prévue sur et/ou dans une certaine des au moins deux structures de couche électriquement isolante (102),
dans lequel le premier espacement de ligne et le deuxième espacement de ligne sont supérieurs au troisième espacement de ligne,
dans lequel la troisième structure de couche électroconductrice (120) est agencée entre la première structure de couche électroconductrice (110a) et la deuxième structure de couche électroconductrice (110b) dans la direction d'empilement (z) de l'empilement (101) ; et
une connexion électroconductrice (130) qui connecte électriquement la première structure de couche électroconductrice (110a) et la deuxième structure de couche électroconductrice (110b) dans la direction d'empilement (z),
**caractérisé en ce que**
la connexion électroconductrice (130) passe à travers la troisième structure de couche électroconductrice (120) au niveau d'une structure de couche de connexion (135).

2. Support de composant (100) selon la revendication 1, dans lequel au moins l'une des caractéristiques suivantes s'applique :
dans lequel la première structure de couche électroconductrice (110a), la troisième structure de couche électroconductrice (120) et la deuxième structure de couche électroconductrice (110b) sont agencées l'une au-dessus de l'autre le long de la hauteur verticale (z) de l'empilement (101), en particulier sont agencées en parallèle ;
dans lequel l'épaisseur de la troisième structure de couche électroconductrice (120) est inférieure à l'épaisseur de la première structure de couche électroconductrice (110a) et de la deuxième structure de couche électroconductrice (110b) ;
dans lequel le premier espacement de ligne et le deuxième espacement de ligne sont de 12/12 µm ou moins, en particulier de 10/10 µm ou moins, plus particulièrement de 8/8 µm ou moins ;
et/ou dans lequel le troisième espacement de ligne est de 5/5 µm ou moins, en particulier de 3/3 µm ou moins, plus particulièrement de 2/2 µm ou moins ;
dans lequel la plus grande extension de la connexion électroconductrice (130) perpendiculaire à la direction d'empilement (z) est de 40 µm ou moins, en particulier de 10 µm ou moins.

3. Support de composant (100) selon la revendication 1 ou 2, comprenant en outre :
une quatrième structure de couche électroconductrice (120b), comprenant un quatrième espacement de ligne, en particulier comparable ou égal au troisième espacement de ligne, disposé dans la direction d'empilement (z) au-dessus ou au-dessous de la deuxième structure de couche électroconductrice (120a), et entre la première structure de couche électroconductrice (110a) et la deuxième structure de couche électroconductrice (110b).

4. Support de composant (100) selon la revendication 3, dans lequel la connexion électroconductrice (130) s'étend à travers la quatrième structure de couche électroconductrice (120b) au niveau d'une structure de couche de connexion supplémentaire (135b).

5. Support de composant (100) selon l'une quelconque des revendications précédentes, dans lequel la plus grande extension de la connexion électroconductrice (130) perpendiculaire à la direction d'empilement (z) est différente de la plus grande extension de la structure de couche de connexion (135).

6. Support de composant (100) selon la revendication 3, comprenant en outre :
une couche de germination (138), en particulier comprenant du titane et/ou du cuivre ;
dans lequel la couche de germination (138) est agencée au niveau d'au moins une paroi latérale et/ou du fond de la connexion électroconductrice (130) ; et/ou
dans lequel la couche de germination (138) est agencée au niveau du fond de la première structure de couche électroconductrice (110a) et/ou de la seconde structure électroconductrice (110b) ; et/ou
dans lequel la couche de germination (138) est agencée au niveau du fond de la deuxième structure de couche électroconductrice (120a) et/ou de la quatrième structure de couche électroconductrice (120b).

7. Support de composant (100) selon la revendication 6,
dans lequel l'extension verticale de la connexion électroconductrice (130) comprend une contre-dépouille (139) à la hauteur verticale (z) de la structure de couche de connexion (135),
en particulier dans lequel la couche de germination (138) comprend ladite contre-dépouille (139) à la hauteur verticale de la structure de couche de connexion (135).

8. Support de composant (100) selon la revendication 6,
dans lequel la connexion électroconductrice (130) comprend un gradin (137), en particulier un gradin horizontal, directement au-dessus de la hauteur verticale (z) de la structure de couche de connexion (135),
en particulier dans lequel la couche de germination (138) comprend ledit gradin (137).

9. Support de composant (100) selon l'une quelconque des revendications précédentes, comprenant en outre :
une structure de redistribution (160), en particulier dans lequel la connexion électroconductrice (130) est directement connectée à la structure de redistribution (160).

10. Agencement de support de composant (150), comprenant :
un support de composant (100) selon l'une quelconque des revendications précédentes ; et
un composant (180, 190), en particulier un support de composant supplémentaire, agencé sur et/ou dans le support de composant (100) ;
en particulier, dans lequel l'agencement de support de composant (150) est sans noyau et/ou exempt d'un interposeur.

11. Procédé de fabrication d'un support de composant (100), le procédé comprenant les étapes consistant à :
former au moins une structure de couche électriquement isolante (102) ;
former une première structure de couche électroconductrice (110a), comprenant un premier espacement de ligne, dans et/ou sur la structure de couche électriquement isolante (102) ;
former une troisième structure de couche électroconductrice (120), comprenant un troisième espacement de ligne, dans une direction d'empilement (z) sur la première structure de couche électroconductrice (110a) ;
former une structure de couche de connexion (135) ;
former une deuxième structure de couche électroconductrice (110b), comprenant un deuxième espacement de ligne, dans la direction d'empilement (z) sur la troisième structure de couche électroconductrice (120),
dans lequel le premier espacement de ligne et le deuxième espacement de ligne sont supérieurs au troisième espacement de ligne ;
former une connexion électroconductrice (130) pour connecter électriquement la première structure de couche électroconductrice (110a) et la deuxième structure de couche électroconductrice (110b) dans la direction d'empilement (z), de sorte que la structure de couche de connexion (135) est agencée là où la connexion électroconductrice (130) passe à travers la troisième structure de couche électroconductrice (120).

12. Procédé selon la revendication 11, dans lequel la formation de la connexion électroconductrice (130) comprend les étapes consistant à :
former un trou (195), en particulier en utilisant un laser, à travers la troisième structure de couche électroconductrice (120) jusqu'à la structure de couche électroconductrice (110), en particulier fournir ensuite une couche de germination (138) ; et
remplir au moins partiellement le trou (195) avec un matériau électroconducteur.

13. Procédé selon la revendication 11, dans lequel la formation de la connexion électroconductrice (130) comprend les étapes consistant à :
former un trou (195a), en particulier en utilisant un laser, jusqu'à la troisième structure de couche électroconductrice (120) ;
effectuer une étape de gravure pour retirer une partie de la troisième structure de couche électroconductrice (120) au niveau du fond trou, en produisant ainsi une contre-dépouille (139) au niveau de la paroi latérale de trou ;
former en outre le trou (195b), en particulier en utilisant le laser, jusqu'à la structure de couche électroconductrice (110), en particulier en fournissant ensuite une couche de germination (138) ; et
remplir au moins partiellement le trou (195) avec un matériau électroconducteur.

14. Procédé selon la revendication 11, dans lequel la formation de la connexion électroconductrice (130) comprend les étapes consistant à :
retirer une partie de la troisième structure de couche électroconductrice (120), puis
intégrer la troisième structure de couche électroconductrice (120) dans une structure de couche électriquement isolante (102) ;
former un trou (195) sur la structure de couche électriquement isolante (102), en particulier en utilisant un laser, jusqu'à la structure de couche électroconductrice (110), en produisant ainsi un gradin (137) entre ladite structure de couche électriquement isolante (102) et la troisième structure de couche électroconductrice (120), en particulier en fournissant ensuite une couche de germination (138) ; et
remplir au moins partiellement le trou (195) avec un matériau électroconducteur.

15. Procédé selon l'une quelconque des revendications 11 à 14,
dans lequel la formation de la première et/ou de la deuxième structure de couche électroconductrice (110) et/ou de la troisième structure de couche électroconductrice (120) comprend un processus soustractif et/ou un processus semi-additif, et/ou un processus semi-additif modifié.
